# EUROPÄISCHE PATENTANMELDUNG

(11) **EP 1 536 431 A1**
(43) Veröffentlichungstag der Anmeldung: **01.06.2005**
(21) Anmeldenummer: 03027143.1
(22) Anmeldetag: 26.11.2003
(51) Int. Cl.: G11C 29/00

(54) **Anordnung mit einem Speicher zum Speichern von Daten**

(71) Anmelder: Infineon Technologies AG, 81669 München (DE)
(72) Erfinder: Kock, Ernst Josef, Dr., 85614 Kirchseeon (DE); Mischo, Walter, Dr., 80339 München (DE)
(74) Vertreter: Repkow, Ines, Dr. Dipl.-Ing.

(57) **Zusammenfassung**

Es wird eine Anordnung beschrieben, mit
- einem ersten Speicher zum Speichern von Daten,
- Schalteinrichtungen, durch welche festgelegt wird, ob bei einem Zugriff auf den ersten Speicher die im ersten Speicher gespeicherten Daten oder andere Daten ausgegeben werden, und
- einem zweiten Speicher zum Speichern der anderen Daten.

Die beschriebene Anordnung zeichnet sich dadurch aus, daß sie einen dritten Speicher enthält, der durch die Adresse, unter Verwendung welcher auf den ersten Speicher zugegriffen wird, oder durch einen Teil dieser Adresse adressiert wird und Informationen darüber enthält, welche Daten des ersten Speichers durch andere Daten zu ersetzen sind.

## Beschreibung

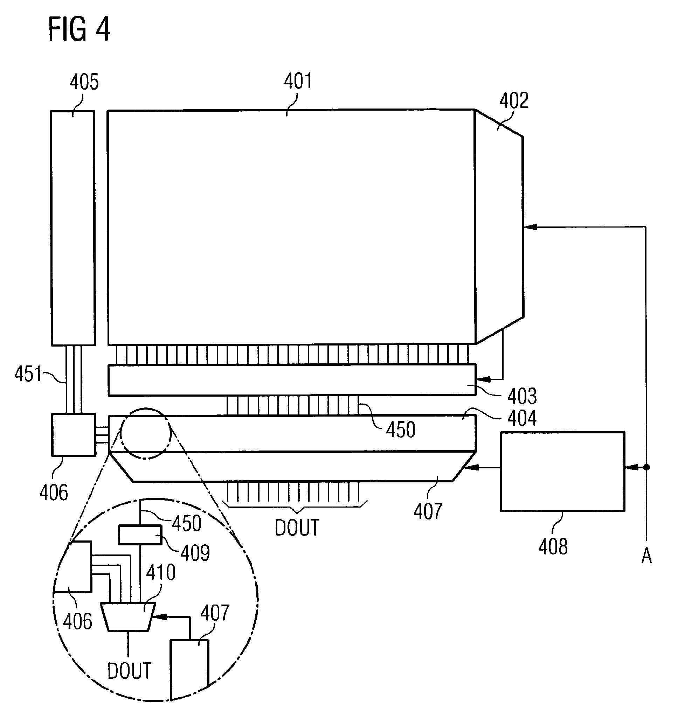

Die vorliegende Erfindung betrifft eine Anordnung gemäß dem Oberbegriff des Patentanspruchs 1, d.h. eine Anordnung mit
- einem ersten Speicher zum Speichern von Daten,
- Schalteinrichtungen, durch welche festgelegt wird, ob bei einem Zugriff auf den ersten Speicher die im ersten Speicher gespeicherten Daten oder andere Daten ausgegeben werden, und
- einem zweiten Speicher zum Speichern der anderen Daten.
   Der zweite Speicher ist beispielsweise ein Speicher zum Speichern von Daten, die eigentlich im ersten Speicher zu speichern wären, aber dort nicht gespeichert werden können, weil die für die Speicherung dieser Daten zu verwendenden Speicherelemente des ersten Speichers defekt sind. Speicher nach Art des zweiten Speichers werden häufig auch als Redundanzspeicher bezeichnet. Bei einer solchen Anordnung kann durch die Schalteinrichtungen festgelegt werden, ob bei einem Zugriff auf den ersten Speicher die im ersten Speicher gespeicherten Daten oder die im zweiten Speicher gespeicherten Daten ausgegeben werden.
   Eine herkömmliche Anordnung dieser Art ist in der Figur 4 veranschaulicht.
   Die in der Figur 4 gezeigte Anordnung umfaßt einen ersten Speicher 401, einen ersten Adreßdecoder 402, einen zweiten Adreßdecoder 403, eine Leseverstärker- und Auswahleinheit 404, einen zweiten Speicher 405, eine Leseverstärkereinheit 406, eine Steuereinrichtung 407, und eine Überprüfungseinrichtung 408.
   Die Hauptkomponente der in der Figur 4 gezeigten Anordnung ist der erste Speicher 401. Dieser Speicher ist ein Speicher zum Speichern von Daten, und auf diesen Speicher wird standardmäßig zugegriffen, wenn in die Anordnung Daten zu schreiben sind oder wenn aus der Anordnung Daten auszulesen sind. Der erste Speicher 401 kann wie jede elektrische oder elektronische Einrichtung Fehler enthalten. Genauer gesagt kann er defekte Speicherelemente enthalten, in welchen keine Daten gespeichert werden können oder sollten. Die Daten, die aufgrund von im ersten Speicher 401 vorhandenen Defekten nicht im ersten Speicher 401 gespeichert werden können oder sollten, werden im zweiten Speicher 405 gespeichert. Der zweite Speicher 405 ist ein Redundanzspeicher zum Speichern von Daten, die eigentlich im ersten Speicher 401 zu speichern wären, aber dort nicht gespeichert werden können, weil die für die Speicherung zu verwendenden Speicherelemente des ersten Speichers defekt sind.
   Die Steuereinrichtung 407, die Überprüfungseinrichtung 408, und Teile der Leseverstärker- und Auswahleinheit 404 sorgen dafür, daß bei Zugriffen auf defekte Bereiche des ersten Speichers 401 im zweiten Speicher 405 gespeicherte Daten ausgegeben werden.

### Dies wird im folgenden näher erläutert:

Wenn aus dem Speicher 401 Daten ausgelesen werden sollen, wird der Anordnung eine Adresse A zugeführt, unter welcher die benötigten Daten innerhalb des ersten Speichers 401 gespeichert sind. Die Adresse A wird dem ersten Adreßdecoder 402 und dem zweiten Adreßdecoder 403 zugeführt. Der erste Adreßdecoder 402 wählt die Wortleitung aus, an welcher die auszulesenden Speicherelemente angeschlossen sind, und der zweite Adreßdecoder 403 wählt die Bitleitungen aus, an welchen die auszulesenden Speicherelemente angeschlossen sind. Die durch den zweiten Adreßdecoder 403 ausgewählten Bitleitungen sind über Leitungen 450 mit der Leseverstärker- und Auswahleinheit 404 verbunden. Die Leseverstärker- und Auswahleinheit 404 enthält eine der Anzahl der Leitungen 450 entsprechende Anzahl von Leseverstärkern 409, und die selbe Anzahl von im allgemeinen durch Multiplexer 410 gebildeten Schalteinrichtungen. Die Leseverstärker sind eingangsseitig mit den Leitungen 450 verbunden und ermitteln in bekannter Weise den Inhalt der auszulesenden Speicherelemente des ersten Speichers 401.

Gleichzeitig mit dem Auslesen von Daten aus dem ersten Speicher 401 werden aus dem zweiten Speicher 405 Daten ausgelesen. Im betrachteten Beispiel werden jeweils alle Speicherelemente ausgelesen, die mit einer der ausgewählten Wortleitung des ersten Speichers 401 zugeordneten Wortleitung des zweiten Speichers 405 verbunden sind. Im betrachteten Beispiel werden jeweils drei Speicherelemente des zweiten Speichers ausgelesen. Die mit den auszulesenden Speicherelementen des zweiten Speichers 405 verbundenen Bitleitungen 451 sind mit der Leseverstärkereinheit 406 verbunden. Die Leseverstärkereinheit 406 enthält eine der Anzahl der Leitungen 451 entsprechende Anzahl von Leseverstärkern. Die Leseverstärker sind eingangsseitig mit den Leitungen 451 verbunden und ermitteln in bekannter Weise den Inhalt der auszulesenden Speicherelemente des zweiten Speichers 405.

Die Ausgangssignale der Leseverstärker 409 der Leseverstärker- und Auswahleinheit 404, und die Ausgangssignale der Leseverstärker der Leseverstärkereinheit 406 werden den in der Leseverstärker- und Auswahleinheit 404 vorgesehenen Multiplexern 410 zugeführt. Genauer gesagt werden jedem Multiplexer 410 das Ausgangssignal eines zugeordneten Leseverstärkers 409 der Leseverstärker- und Auswahleinheit 404, und die Ausgangssignale sämtlicher Leseverstärker der Leseverstärkereinheit 406 zugeführt. Die Multiplexer 410 werden durch die Steuereinrichtung 407 gesteuert. Die Multiplexer 410 geben Daten DOUT aus, welche zugleich die von der Anordnung als Reaktion auf den Zugriff auf die Anordnung auszugebenden Daten sind.

Die Steuerung der Multiplexer 410 durch die Steuereinrichtung 407 erfolgt in Abhängigkeit davon, ob sich unter den auszulesenden Speicherelementen des ersten Speichers 401 defekte Speicherelemente befinden oder nicht.

Ob dies der Fall ist, wird der Steuereinrichtung 407 von der Überprüfungseinrichtung 408 mitgeteilt. In der Überprüfungseinrichtung 408 sind die Adressen gespeichert, deren Verwendung einen Zugriff auf defekte Speicherelemente beinhaltet. Die Überprüfungseinrichtung 408 überprüft, ob die der Anordnung zugeführte Adresse A mit einer der in der Überprüfungseinrichtung 408 gespeicherten Adressen übereinstimmt, und teilt der Steuereinrichtung 407 das Ergebnis dieser Überprüfung mit.

Die Steuereinrichtung 407 ermittelt sodann, wie sie die Multiplexer 410 ansteuern muß. Sie steuert die Multiplexer 410 so an,
- daß diese das ihnen vom Leseverstärker 409 zugeführte Signal durchschalten, falls das Speicherelement des ersten Speichers 401, dessen Inhalt durch das betreffende Signal repräsentiert wird, nicht defekt ist, und
- daß diese eines der ihnen von der Leseverstärkereinheit 406 zugeführten Signale durchschalten, falls das Speicherelement des ersten Speichers 401, dessen Inhalt durch das Ausgangssignal des Leseverstärkers repräsentiert wird, defekt ist.

Auf diese Art und Weise können auch dann, wenn der erste Speicher 401 defekte Speicherelemente enthält, stets korrekte Daten ausgegeben werden, und zwar ohne daß der Benutzer hierfür irgendwelche Besonderheiten berücksichtigen muß; aus der Sicht des Benutzers stellt es keinen Unterschied dar, ob auf einen fehlerfreien ersten Speicher oder einen fehlerbehafteten ersten Speicher zugegriffen wird.

Allerdings ist das Ersetzen von defekten Speicherelementen des ersten Speichers 401 durch zugeordnete Speicherelemente des zweiten Speichers 405 mit einem erheblichen Aufwand verbunden. Insbesondere die Vergleiche der Adresse A mit den in der Überprüfungseinrichtung 408 gespeicherten Adressen sowie die durch die Steuereinrichtung 407 durchgeführte Ermittlung der die Multiplexer 410 steuernden Steuersignale ist sehr zeitaufwendig, so daß die Daten DOUT, die aus Anordnungen der in der Figur 4 gezeigten Art ausgegeben werden, im allgemeinen später zur Verfügung stehen als es bei Anordnungen ohne Redundanzspeicher der Fall ist.

Der vorliegenden Erfindung liegt daher die Aufgabe zugrunde, die Anordnung gemäß dem Oberbegriff des Patentanspruchs 1 derart weiterzubilden, daß die aus der Anordnung auszugebenden Daten früher zur Verfügung stehen als es bei herkömmlichen Anordnungen dieser Art der Fall ist.

Diese Aufgabe wird erfindungsgemäß durch die in Patentanspruch 1 beanspruchte Anordnung gelöst.

Die erfindungsgemäße Anordnung zeichnet sich dadurch aus, daß sie einen dritten Speicher enthält, der durch die Adresse, unter Verwendung welcher auf den ersten Speicher zugegriffen wird, oder durch einen Teil dieser Adresse adressiert wird und Informationen darüber enthält, welche Daten des ersten Speichers durch andere Daten zu ersetzen sind.

Dadurch kann sehr einfach und schnell ermittelt werden, wie die Schalteinrichtungen jeweils anzusteuern sind. Die Ermittlung kann problemlos so schnell und einfach durchgeführt werden, daß sich dadurch keine Verzögerung der Ausgabe der aus der Anordnung auszugebenden Daten ergibt.

Darüber hinaus weist die beanspruchte Anordnung einen wesentlich einfacheren Aufbau als herkömmliche Anordnungen mit einem Redundanzspeicher auf.

Vorteilhafte Weiterbildungen der Erfindung sind den Unteransprüchen, der folgenden Beschreibung, und den Figuren entnehmbar.

Die Erfindung wird nachfolgend anhand von Ausführungsbeispielen unter Bezugnahme auf die Figuren näher erläutert. Es zeigen
- Figur 1: den Aufbau einer ersten Anordnung mit einem Redundanzspeicher,
- Figur 2: den Aufbau einer zweiten Anordnung mit einem Redundanzspeicher,
- Figur 3: den Aufbau einer dritten Anordnung mit einem Redundanzspeicher, und
- Figur 4: den Aufbau einer herkömmlichen Anordnung mit einem Redundanzspeicher.

Die im folgenden beschriebenen Anordnungen sind im betrachteten Beispiel Bestandteil einer programmgesteuerten Einheit wie beispielsweise eines Mikroprozessors, eines Mikrocontrollers, oder eines Signalprozessors. Es sei jedoch bereits an dieser Stelle darauf hingewiesen, daß hierauf keine Einschränkung besteht. Die im folgenden beschriebenen Anordnungen können auch Bestandteil beliebiger anderer Bauteile sein.

Den im folgenden beschriebenen Anordnungen ist gemeinsam, daß sie folgende Komponenten aufweisen:
- einen ersten Speicher zum Speichern von Daten,
- Schalteinrichtungen, durch welche festgelegt wird, ob bei einem Zugriff auf den ersten Speicher die im ersten Speicher gespeicherten Daten oder andere Daten ausgegeben werden,
- einen zweiten Speicher zum Speichern der anderen Daten, und
- einen dritten Speicher, der durch die Adresse, unter Verwendung welcher auf den ersten Speicher zugegriffen wird, oder durch einen Teil dieser Adresse adressiert wird und Informationen darüber enthält, welche Daten des ersten Speichers durch andere Daten zu ersetzen sind.

Der erste Speicher und der dritte Speicher werden vorzugsweise durch zwei separate Speicher gebildet. Im betrachteten Beispiel wird der erste Speicher durch einen Flash-Speicher gebildet, und der dritte Speicher durch ein RAM. Hierauf besteht jedoch keine Einschränkung. Der erste Speicher und der dritte Speicher können unabhängig voneinander durch beliebige Speichertypen gebildet werden. Darüber hinaus besteht auch keine zwingende Notwendigkeit, daß der erste Speicher und der dritte Speicher durch separate Speicher gebildet werden. Diese Speicher könnten prinzipiell auch durch verschiedene Speicherbereiche des selben Speichers gebildet werden.

Der zweite Speicher kann ein separater Speicher sein, oder Bestandteil eines zugleich auch den ersten Speicher bildenden Speichers sein, oder Bestandteil eines zugleich auch den dritten Speicher bildenden Speichers sein.

Im betrachteten Beispiel sind im zweiten Speicher Daten gespeichert, die eigentlich im ersten Speicher zu speichern wären, aber dort nicht gespeichert werden können, weil die für die Speicherung zu verwendenden Speicherelemente des ersten Speichers defekt sind. In diesem Fall kann durch eine entsprechende Ansteuerung der Schalteinrichtungen erreicht werden, daß auch dann, wenn der erste Speicher defekte Speicherelemente enthält, stets korrekte Daten ausgegeben werden, und zwar ohne daß der Benutzer der Anordnung hierfür irgendwelche Besonderheiten berücksichtigen muß; aus der Sicht des Benutzers stellt es keinen Unterschied dar, ob auf einen fehlerfreien ersten Speicher oder einen fehlerbehafteten ersten Speicher zugegriffen wird.

In den im folgenden beschriebenen Beispielen ist es so, daß durch einen Zugriff auf den ersten Speicher auch Zugriffe auf den zweiten Speicher und den dritten Speicher bewirkt werden; aus dem ersten Speicher, dem zweiten Speicher, und dem dritten Speicher werden gleichzeitig einander zugeordnete Daten ausgelesen. Der Vollständigkeit halber sei jedoch bereits an dieser Stelle darauf hingewiesen, daß dies keine zwingende Notwendigkeit ist. Das Auslesen der genannten Speicher kann auch zeitversetzt erfolgen, und darüber hinaus kann auch vorgesehen werden, daß der zweite Speicher und/oder der dritte Speicher nur ausgelesen werden, wenn ein konkreter Anlaß hierfür vorliegt.

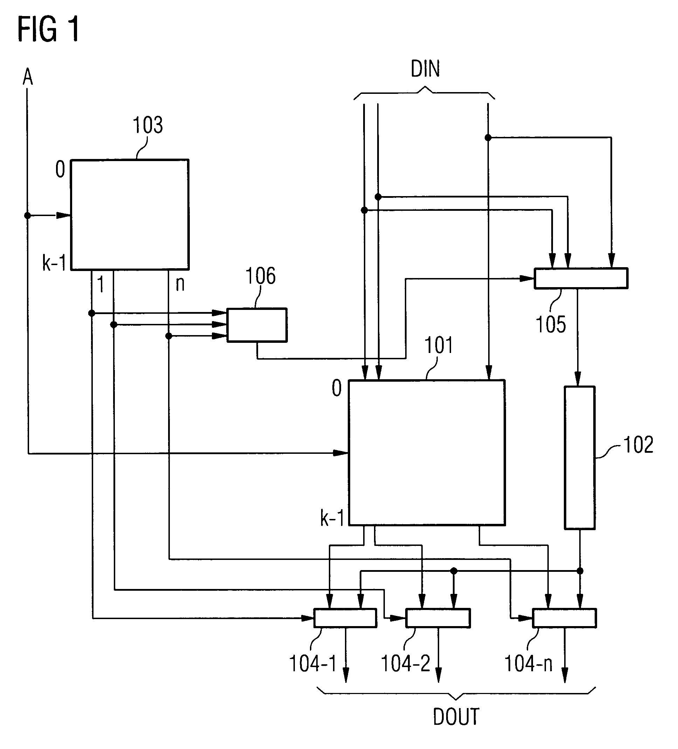

Die in der Figur 1 gezeigte Anordnung enthält einen ersten Speicher 101, einen zweiten Speicher 102, einen dritten Speicher 103, erste Schalteinrichtungen 104-1 bis 104-n, eine zweite Schalteinrichtung 105, und eine Steuereinrichtung 106.

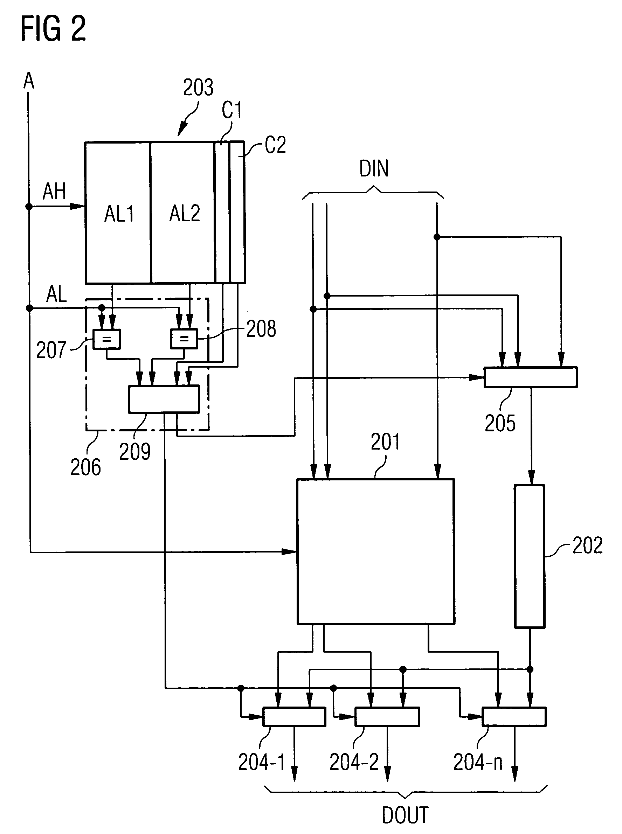

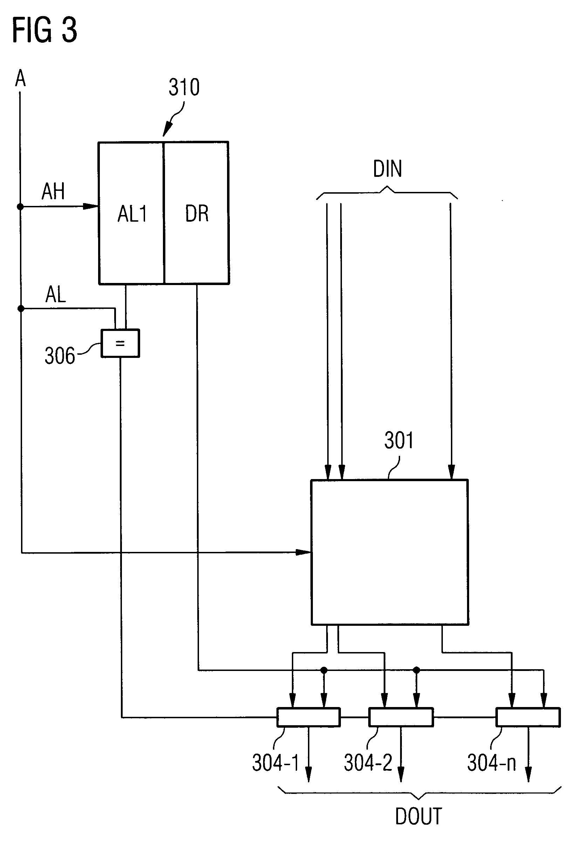

Die Anordnung enthält darüber hinaus Adreßdecoder, Leseverstärker etc., die jedoch in der Figur 1 nicht gezeigt sind. Dies gilt übrigens auch für die in den Figuren 2 und 3 beschriebenen Anordnungen.

Der erste Speicher 101, der zweite Speicher 102, und die ersten Schalteinrichtungen 104-1 bis 104-n entsprechen hinsichtlich des Aufbaus, der Verschaltung, und der Funktion dem ersten Speicher 401, dem zweiten Speicher 405, und den Schalteinrichtungen 410 der eingangs unter Bezugnahme auf die Figur 4 beschriebenen herkömmlichen Anordnung.

Unterschiedlich sind aber insbesondere die Art und Weise, auf welche die ersten Schalteinrichtungen 104-1 bis 104-n angesteuert werden, und daß in der Anordnung gemäß Figur 1 zusätzlich veranschaulicht ist, wie beim Einschreiben von Daten in den zweiten Speicher 102 vorgegangen wird. Ein weiterer Unterschied besteht darin, daß aus dem zweiten Speicher nur jeweils 1 Bit umfassende Datenworte ausgegeben werden, wobei hierauf jedoch keine Einschränkung besteht; die aus dem zweiten Speicher 102 ausgegebenen Datenworte können prinzipiell beliebig viele Bits umfassen, wobei (wie bei der Anordnung gemäß Figur 4 jeweils alle Datenbits an alle ersten Schalteinrichtungen 104-1 bis 104-n angelegt werden.

Bei der in der Figur 1 gezeigten Anordnung erfolgt die Ansteuerung der ersten Schalteinrichtungen 104-1 bis 104-n unter Verwendung von Steuerdaten, die im dritten Speicher 103 gespeichert sind. Im dritten Speicher 103 sind Steuerdatenworte gespeichert, die im betrachteten Beispiel jeweils eine der Anzahl der ersten Schalteinrichtungen 104-1 bis 104-n entsprechende Anzahl von Bits umfassen. Die einzelnen Bits werden direkt, d.h. ohne eine vorherige Decodierung oder sonstige Verarbeitung als Steuersignale zur Steuerung der ersten Schalteinrichtungen 104-1 bis 104-n verwendet. Genauer gesagt ist es so, daß das Bit 1 eines jeweiligen Steuerdatenwortes zur Ansteuerung der ersten Schalteinrichtung 104-1 verwendet wird, das Bit 2 eines jeweiligen Steuerdatenwortes zur Ansteuerung der ersten Schalteinrichtung 104-2 verwendet wird, das Bit 3 eines jeweiligen Steuerdatenwortes zur Ansteuerung der ersten Schalteinrichtung 104-3 verwendet wird, ... und das Bit n eines jeweiligen Steuerdatenwortes zur Ansteuerung der ersten Schalteinrichtung 104-n verwendet wird. Wenn die ersten Schalteinrichtungen 104-1 bis 104-n mehr als zwei Eingangsanschlüsse aufweisen und demzufolge mehr als 1 Bit zur Ansteuerung derselben benötigt wird, wird ein dritter Speicher verwendet, dessen Steuerdatenworte eine entsprechend größere Anzahl von Bits umfassen.

Dem dritten Speicher 103 wird die selbe Adresse A zugeführt wie dem ersten Speicher 101, und der Adreßraum des dritten Speichers 103 stimmt mit dem Adreßraum des ersten Speichers 101 exakt überein. Somit ist für jedes Datenwort, das aus dem ersten Speicher 101 ausgelesen wird, im dritten Speicher ein zugeordnetes Steuerdatenwort gespeichert.

Diese Art der Ansteuerung der ersten Schalteinrichtungen 104-1 bis 104-n, genauer gesagt diese Art der Beschaffung der für die Ansteuerung der ersten Schalteinrichtungen 104-1 bis 104-n benötigten Steuerdaten erweist sich in mehrfacher Hinsicht als vorteilhaft:
- erstens kann für jedes Datenwort, das aus dem ersten Speicher 101 ausgelesen wird, individuell, d.h. unabhängig von allen anderen Datenworten festgelegt werden, ob und gegebenenfalls welches Bit des betreffenden Datenwortes durch ein im zweiten Speicher 102 gespeichertes Bit zu ersetzen ist,
- zweitens erfolgt die Beschaffung der zur Ansteuerung der ersten Schalteinrichtungen 104-1 bis 104-n benötigten Steuerdaten innerhalb von kürzester Zeit, so daß die aus der Anordnung auszugebenden Daten DOUT früher bereitstehen als es beispielsweise bei der Anordnung gemäß Figur 4 der Fall ist, und
- drittens muß keine kompliziert aufgebaute Steuereinrichtung zur Ermittlung der Steuersignale für die ersten Schalteinrichtungen 104-1 bis 104-n vorgesehen werden.

Die Festlegung, welches Bit der in den ersten Speicher 101 zu schreibenden Daten DIN in den zweiten Speicher 102 zu schreiben ist, kann ähnlich schnell und einfach erfolgen. Die in den ersten Speicher 101 zu schreibenden Daten DIN werden nicht nur dem ersten Speicher 101 zugeführt, sondern zusätzlich auch der dem zweiten Speicher 102 vorgeschalteten zweiten Schalteinrichtung 105. Die zweite Schalteinrichtung 105 wird im betrachteten Beispiel wie auch die ersten Schalteinrichtungen 104-1 bis 104-n durch einen Multiplexer gebildet. Der die (einzige) zweite Schalteinrichtung 105 bildende Multiplexer wird jedoch anders angesteuert als die die (vielen) ersten Schalteinrichtungen 104-1 bis 104-n bildenden Multiplexer; die Ansteuerung des die zweite Schalteinrichtung 105 bildenden Multiplexers erfolgt zwar ebenfalls unter Berücksichtigung der im dritten Speicher 103 gespeicherten Steuerdaten, doch können diese Steuerdaten nicht direkt verwendet werden, sondern müssen umcodiert werden. Die Umcodierung erfolgt durch die Steuereinrichtung 106. Die Steuerdaten werden so umcodiert, daß von den in den ersten Speicher 101 zu schreibenden Daten DIN dasjenige Bit in den zweiten Speicher 102 geschrieben wird, welches gemäß den im dritten Speicher 103 gespeicherten Steuerdaten beim einem späteren Auslesen der im ersten Speicher 101 gespeicherten Daten durch das im zweiten Speicher 102 gespeicherte Bit ersetzt werden muß. Eine solche Umcodierung ist mit einem sehr geringen Aufwand möglich, so daß die Steuereinrichtung 106 einerseits sehr einfach aufgebaut sein kann, und die Umcodierung innerhalb kürzester Zeit erfolgen kann.

Es kann sich als vorteilhaft erweisen, wenn die in der Figur 1 gezeigte Anordnung dahingehend modifiziert wird, daß die im dritten Speicher 103 enthaltenen Steuerdaten in codierter Form gespeichert werden. Beispielsweise kann vorgesehen werden, daß die Steuerdaten in binär codierter Form die Nummer des Bits repräsentieren, das von den aus dem ersten Speicher 101 ausgegebenen Bits durch das aus dem zweiten Speicher 102 ausgegebene Bit zu ersetzen ist. In diesem Fall müßte zwischen dem dritten Speicher 103 und den ersten Schalteinrichtungen 104-1 bis 104-n eine Decodiervorrichtung vorgesehen werden, die die im dritten Speicher 103 gespeicherten Steuerdaten in die Steuerdaten umsetzt, die zur Ansteuerung der ersten Schalteinrichtungen 104-1 bis 104-n benötigt werden. Im Gegenzug könnte aber die Steuereinrichtung 106 entfallen, und darüber hinaus könnte der dritte Speicher 103 sehr viel kleiner ausgebildet werden als es bei der in der Figur 1 gezeigten Anordnung der Fall ist. Da die von der zusätzlichen Decodiervorrichtung vorzunehmende Decodierung sehr einfach durchzuführen ist, kann die Decodiervorrichtung sehr einfach aufgebaut sein und die von der Decodiervorrichtung durchzuführende Decodierung innerhalb kürzester Zeit erfolgen, so daß sich auch in diesem Fall die Vorteile wie bei der in der Figur 1 gezeigten Anordnung ergeben.

Wenn aus dem zweiten Speicher 102 pro Lesezugriff auf den ersten Speicher 101 mehr als 1 redundantes Bit ausgegeben wird, kann eine Reduzierung des Aufwandes zur Realisierung der Anordnung gemäß Figur 1 auch dadurch erzielt werden, daß nicht jedes redundante Bit an alle ersten Schalteinrichtungen 104-1 bis 104-n angelegt wird. Beispielsweise könnte vorgesehen werden, daß ein erstes redundantes Bit nur an die den höherwertigen Bits der Ausgangsdaten DOUT zugeordneten ersten Schalteinrichtungen angelegt wird, und daß ein zweites redundantes Bit nur an die den niederwertigen Bits der Ausgangsdaten DOUT zugeordneten ersten Schalteinrichtungen angelegt wird.

Die in der Figur 2 gezeigte Anordnung enthält einen ersten Speicher 201, einen zweiten Speicher 202, einen dritten Speicher 203, erste Schalteinrichtungen 204-1 bis 204-n, eine zweite Schalteinrichtung 205, und eine Steuereinrichtung 206, wobei die Steuereinrichtung 206 eine erste Vergleichseinrichtung 207, eine zweite Vergleichseinrichtung 208, und eine Auswertungseinrichtung 209 enthält.

Der erste Speicher 201, der zweite Speicher 202, die ersten Schalteinrichtungen 204-1 bis 204-n, und die zweite Schalteinrichtung 205 entsprechen dem ersten Speicher 101, dem zweiten Speicher 102, den ersten Schalteinrichtungen 104-1 bis 104-n, und der zweiten Schalteinrichtung 105 der in der Figur 1 gezeigten Anordnung.

Unterschiedlich ist aber, wie die Steuersignale für die ersten Schalteinrichtungen 204-1 bis 204-n und die zweite Schalteinrichtung 205 ermittelt werden. Die Ermittlung erfolgt zwar auch hier unter Berücksichtigung der im dritten Speicher 203 gespeicherten Steuerdaten, doch unterscheiden sich die Steuerdaten von den Steuerdaten, die im dritten Speicher 103 der Anordnung gemäß Figur 1 gespeichert sind. Darüber hinaus wird der dritte Speicher 203 auch anders adressiert.

Der erste Speicher 201 wird wie der erste Speicher 101 der Anordnung gemäß Figur 1 unter Verwendung einer Adresse A adressiert. Zur Adressierung des dritten Speichers 203 wird jedoch eine Adresse AH verwendet, wobei die Adresse AH ein bestimmter Teil der Adresse A ist. Genauer gesagt handelt es sich bei der Adresse AH um einen nur eine bestimmte Anzahl der höchstwertigen Bits der Adresse A umfassenden Teil der Adresse A, wobei die Anzahl der höchstwertigen Bits beliebig groß sein kann. Auf das Anlegen der Adresse AH an den dritten Speicher 203 gibt dieser ein Datenwort aus, das einen ersten Adreßteil AL1, einen zweiten Adreßteil AL2, eine dem ersten Adreßteil AL1 zugeordnete Information C1, und eine dem zweiten Adreßteil AL2 zugeordnete Information C2 umfaßt.

Der erste Adreßteil AL1 enthält die niederstwertigen Bits einer ersten Adresse, die auf einen defekte Speicherelemente enthaltenden Bereich innerhalb des ersten Speichers 201 zeigt. Genauer gesagt ist es so,
- daß die an den dritten Speicher 203 angelegte Adresse AH die Basisadresse eines mehrere Datenworte speichernden Bereiches des ersten Speichers 201 ist, und
- daß der erste Adreßteil AL1 die Adresse eines in teilweise defekten Speicherelementen gespeicherten Datenwortes innerhalb des durch die Adresse AH spezifizierten Speicherbereiches im ersten Speicher 201 ist.

Die dem ersten Adreßteil AL1 zugeordnete Information C1 enthält Informationen darüber, wie die Schalteinrichtungen 204-1 bis 204-n und 205 anzusteuern sind, wenn unter einer aus den Adreßteilen AH und AL1 zusammengesetzten Adresse A auf den ersten Speicher 201 zugegriffen wird. Diese Informationen sind beispielsweise die im dritten Speicher 103 der Anordnung gemäß Figur 1 unter der sich aus den Adressen AH und AL1 zusammensetzenden Adresse A gespeicherten Informationen.

Entsprechendes gilt für den zweiten Adreßteil AL2 und die diesem zugeordnete Information. Der zweite Adreßteil AL2 enthält die niederstwertigen Bits einer zweiten Adresse, die auf einen defekte Speicherelemente enthaltenden Bereich innerhalb des ersten Speichers 201 zeigt. Genauer gesagt ist es so,
- daß die an den dritten Speicher 203 angelegte Adresse AH die Basisadresse eines mehrere Datenworte speichernden Bereiches des ersten Speichers 201 ist, und
- daß der zweite Adreßteil AL2 die Adresse eines in teilweise defekten Speicherelementen gespeicherten Datenwortes innerhalb des durch die Adresse AH spezifizierten Speicherbereiches im ersten Speicher 201 ist.

Die dem zweiten Adreßteil AL2 zugeordnete Information C2 enthält Informationen darüber, wie die Schalteinrichtungen 204-1 bis 204-n und 205 anzusteuern sind, wenn unter einer aus den Adreßteilen AH und AL2 zusammengesetzten Adresse A auf den ersten Speicher 201 zugegriffen wird. Diese Informationen sind beispielsweise die im dritten Speicher 103 der Anordnung gemäß Figur 1 unter der sich aus den Adressen AH und AL2 zusammensetzenden Adresse A gespeicherten Informationen.

Der Vollständigkeit halber sei darauf hingewiesen, daß pro Datenwort des dritten Speichers 203 auch mehr oder weniger Adreßteile Alx und zugeordnete Informationen Cx enthalten sein können.

Im Unterschied zur Anordnung gemäß Figur 1 werden bei der Anordnung gemäß Figur 2 nicht für jede Adresse A die zur Ansteuerung der Schalteinrichtungen 204-1 bis 204-n und 205 zu verwendenden Steuerdaten gespeichert, sondern nur für diejenigen Adressen, über welche auf in teilweise defekten Speicherelementen gespeicherte Datenworte zugegriffen wird.

Im Normalfall haben Zugriffe auf den ersten Speicher 201 keinen Zugriff auf defekte Speicherelemente zur Folge, so daß die Schalteinrichtungen 204-1 bis 204-n standardmäßig so angesteuert werden, daß die aus dem ersten Speicher 201 ausgelesenen Daten als Ausgangsdaten DOUT verwendet werden. Nur in bestimmten Fällen, genauer gesagt wenn die Adresse, unter welcher auf den ersten Speicher zugegriffen wird, mit der aus den Adreßteilen AH und AL1 zusammengesetzten Adresse, oder mit der aus den Adreßteilen AH und AL2 zusammengesetzten Adresse übereinstimmen, ist eine andere Ansteuerung der Schaltelemente 204-1 bis 204-n erforderlich, wobei die Ansteuerung in diesen Fällen unter Berücksichtigung der im dritten Speicher 203 gespeicherten Informationen, genauer gesagt unter Berücksichtigung der im dritten Speicher 203 gespeicherten Informationen C1 oder C2 erfolgt.

Die Ansteuerung der Schaltelemente 204-1 bis 204-n erfolgt durch die Steuereinrichtung 206. Die Steuereinrichtung 206 enthält eine der Anzahl der Adreßteile ALx, die in jedem Datenwort des dritten Speicher 203 enthalten sein können, entsprechende Anzahl von Vergleichseinrichtungen, und eine Auswertungseinrichtung. Die Vergleichseinrichtungen sind in der Figur 2 mit den Bezugszeichen 207 und 208 bezeichnet, und die Auswertungseinrichtung mit dem Bezugszeichen 209.

Die Vergleichseinrichtung 207 vergleicht den Adreßteil AL1, der in dem aus dem dritten Speicher 203 ausgegebenen Steuerdatenwort enthalten ist, mit einem Adreßteil AL, wobei der Adreßteil AL die im Adreßteil AH nicht enthaltenen Adreßbits der an den ersten Speicher 201 angelegten Adresse umfaßt. Die Vergleichseinrichtung 208 vergleicht den Adreßteil AL2, der in dem aus dem dritten Speicher 203 ausgegebenen Steuerdatenwort enthalten ist, mit dem Adreßteil AL.

Die Auswertungseinrichtung 209 wertet die Vergleichsergebnisse aus und entscheidet abhängig hiervon, wie die Schalteinrichtungen 204-1 bis 204-n anzusteuern sind. Genauer gesagt ist es so,
- daß dann, wenn weder der von der Vergleichseinrichtung 207 durchgeführte Vergleich noch der von der Vergleichseinrichtung 208 durchgeführte Vergleich eine Übereinstimmung ergeben, die Schalteinrichtungen 204-1 bis 204-n durch die Auswertungseinrichtung 209 so angesteuert werden, daß die aus dem ersten Speicher 201 ausgegebenen Daten als Ausgangsdaten DOUT verwendet werden,
- daß dann, wenn der von der Vergleichseinrichtung 207 durchgeführte Vergleich eine Übereinstimmung ergibt, die Schalteinrichtungen 204-1 bis 204-n durch die Auswertungseinrichtung 209 so angesteuert werden, wie es durch die Steuerdaten C1 vorgegeben ist, und
- daß dann, wenn der von der Vergleichseinrichtung 208 durchgeführte Vergleich eine Übereinstimmung ergibt, die Schalteinrichtungen 204-1 bis 204-n durch die Auswertungseinrichtung 209 so angesteuert werden wie es durch die Steuerdaten C2 vorgegeben ist.

Die Ansteuerung der zweiten Schalteinrichtung 205 (während des Einschreibens von Daten DIN in den ersten Speicher 201 und den zweiten Speicher 202) erfolgt ebenfalls durch die Steuereinrichtung 206. Dabei wird vorgegangen wie bei der Ansteuerung der ersten Schalteinrichtungen 204-1 bis 204-n. Allerdings werden für die (einzige) Schalteinrichtung 205 naturgemäß andere Steuersignale verwendet als für die (vielen) erst Schalteinrichtungen 204-1 bis 204-n), wobei jedoch auch die Festlegung der Steuersignale für die zweite Schalteinrichtung unter Berücksichtigung der Steuerdaten C1 bzw. C2 erfolgt. Diesbezüglich wird ergänzend auf die Ausführungen zur Ansteuerung der zweiten Schalteinrichtung 105 der Anordnung gemäß Figur 1 verwiesen.

Die durch die Steuereinrichtung 206 durchzuführenden Operationen sind einfachster Natur und lassen sich innerhalb kürzester Zeit durchführen. Die in der Figur 2 gezeigte Anordnung weist daher die selben Vorteile auf wie die in der Figur 1 gezeigte Anordnung, und kommt obendrein mit einem erheblich kleineren dritten Speicher aus.

Die in der Figur 3 gezeigte Anordnung enthält einen ersten Speicher 301, einen weiteren Speicher 310, Schalteinrichtungen 304-1 bis 304-n, und eine Steuereinrichtung 306.

Der erste Speicher 301 und die Schalteinrichtungen 304-1 bis 304-n entsprechen dem ersten Speicher 201 und den Schalteinrichtungen 204-1 bis 204-n der in der Figur 2 gezeigten Anordnung.

Der weitere Speicher 310 entspricht einer Kombination des zweiten Speichers 202 und des dritten Speichers 203 der Anordnung gemäß Figur 2. Er enthält einerseits Informationen darüber, welche Daten des ersten Speichers 301 zu ersetzen sind, und speichert zugleich die anderen Daten, welche anstelle der im ersten Speicher gespeicherten Daten ausgegeben werden sollen.

Der Speicher 310 wird durch eine Adresse AH adressiert, die der Adresse AH entspricht, mit welcher der dritte Speicher 203 der Anordnung gemäß Figur 2 adressiert wurde.

Das Datenwort, daß im Ansprechen auf das Anlegen der Adresse AH an den Speicher 310 aus diesem ausgegeben wird, enthält ein Adreßfeld und ein Datenfeld, wobei
- im Adreßfeld ein Adreßteil AL1 gespeichert ist, die dem Adreßteil AL1 entspricht, der in dem aus dem dritten Speicher 203 der Anordnung gemäß Figur 2 ausgegebenen Datenwort enthalten ist, und
- im Datenfeld Daten DR gespeichert sind, die anstelle der im ersten Speicher 301 unter der Adresse A gespeicherten Daten ausgegeben werden sollen, wenn die Adresse A der aus den Teiladressen AH und AL1 zusammengesetzten Adresse entspricht.

Der Adreßteil AL1 wird der Steuereinrichtung 306 zugeführt, und die Daten DR den Schalteinrichtungen 304-1 bis 304-n, so daß jeder Schalteinrichtung 1 Bit der aus dem ersten Speicher ausgegebenen Daten und ein Bit der im Speicher 310 gespeicherten Daten DR zugeführt wird. Die Daten DR enthalten jeweils so viele Bits wie ein Datenwort des ersten Speichers 301, so daß die Daten DR jeweils ein komplettes Speicherwort des ersten Speichers ersetzen können.

Im Normalfall haben Zugriffe auf den ersten Speicher 301 keinen Zugriff auf defekte Speicherelemente zur Folge, so daß die Schalteinrichtungen 304-1 bis 304-n standardmäßig so angesteuert werden, daß die aus dem ersten Speicher 301 ausgelesenen Daten als Ausgangsdaten DOUT verwendet werden. Nur in bestimmten Fällen, genauer gesagt nur wenn die Adresse A, unter welcher auf den ersten Speicher 301 zugegriffen wird, mit der aus den Adreßteilen AH und AL1 zusammengesetzten Adresse übereinstimmt, ist eine andere Ansteuerung der Schaltelemente 204-1 bis 204-n erforderlich. In diesem Fall werden alle Schalteinrichtungen 304-1 bis 304-n so angesteuert, daß die Daten DR als Ausgangsdaten DOUT verwendet werden.

Die Ansteuerung der Schaltelemente 304-1 bis 304-n erfolgt durch die Steuereinrichtung 306. Die Steuereinrichtung 306 wird durch eine Vergleichseinrichtung gebildet. Diese Vergleichseinrichtung vergleicht den Adreßteil AL1, der in dem aus dem Speicher 310 ausgegebenen Datenwort enthalten ist, mit einem Adreßteil AL, wobei der Adreßteil AL die im Adreßteil AH nicht enthaltenen Adreßbits der an den ersten Speicher 301 angelegten Adresse A umfaßt.

Das das Ergebnis dieses Vergleiches repräsentierende Ausgangssignal der Vergleichseinrichtung wird als Steuersignal zur Steuerung der Schalteinrichtungen 304-1 bis 304-n verwendet. Genauer gesagt ist es so,
- daß dann, wenn der von der Vergleichseinrichtung durchgeführte Vergleich keine Übereinstimmung ergibt, die Schalteinrichtungen 304-1 bis 304-n so angesteuert werden, daß die aus dem ersten Speicher 301 ausgegebenen Daten als Ausgangsdaten DOUT verwendet werden, und
- daß dann, wenn der von der Vergleichseinrichtung durchgeführte Vergleich eine Übereinstimmung ergibt, die Schalteinrichtungen 304-1 bis 304-n so angesteuert werden, daß die aus dem Speicher 310 ausgegebenen Daten DR als Ausgangsdaten DOUT verwendet werden.

Beim beschriebenen Beispiel wurde durch die Daten DR jeweils ein komplettes Datenwort des ersten Speichers 301 ersetzt. Es könnte aber auch vorgesehen werden, daß die Daten DR nur jeweils die fehlerhaften Bits der Datenworte des ersten Speichers beinhalten, und daß in jedem Datenwort des Speicher 310 eine zusätzliche Information enthalten ist, die angibt, welche Bits des Datenwortes des ersten Speichers durch welche Bits der Daten DR zu ersetzen sind.

Es könnte auch vorgesehen werden, daß die Daten, die anstelle der im ersten Speicher 301 gespeicherten Daten auszugeben sind, in einem anderen Speicher gespeichert sind, und daß die Datenworte des Speichers 310 anstelle der Daten DR die Adresse enthalten, unter welcher die Daten gespeichert sind, die anstelle der im ersten Speicher gespeicherten Daten auszugeben sind.

Die durch die Steuereinrichtung 306 durchzuführenden Operationen sind einfachster Natur und lassen sich innerhalb kürzester Zeit durchführen. Die in der Figur 3 gezeigte Anordnung weist daher die selben Vorteile auf wie die in der Figur 1 gezeigte Anordnung, und kommt obendrein mit weniger und kleineren Speichern aus.

Insbesondere bei den vorstehend unter Bezugnahme auf die Figuren 1 und 2 beschriebenen Anordnungen, aber auch bei der unter Bezugnahme auf die Figur 3 beschriebene Anordnung kann es sich als vorteilhaft erweisen, wenn sich die im dritten Speicher 103, 203, 310 gespeicherten Informationen nicht jeweils auf einzelne Datenworte des ersten Speichers 101, 201, 301 beziehen, sondern jeweils für mehrere Datenworte umfassende Speicherbereiche gelten.

Unabhängig hiervon kann es sich bei allen hier vorgestellten Anordnungen als vorteilhaft erweisen, wenn im dritten Speicher 103, 203, 310 oder anderswo eine Information gespeichert ist, aus der hervorgeht, ob überhaupt eine Ersetzung der im ersten Speicher 101, 201, 301 gespeicherten Daten durch redundante Daten erfolgen soll, oder ob generell die im ersten Speicher gespeicherten (und eventuell unter Verwendung eines error correction code korrigierten) Daten aus der Anordnung ausgegeben werden sollen. Auch diese Information kann sich je nach Bedarf entweder auf einzelne Datenworte des ersten Speichers, oder auf mehrere Datenworte umfassende Speicherbereiche, oder auf den gesamten ersten Speicher beziehen.

Es kann sich ferner als vorteilhaft erweisen, wenn die aus dem dritten Speicher ausgegebenen Datenworte eine Information enthalten, die angibt, welche Informationen die restlichen Daten des jeweiligen Datenwortes repräsentieren, oder die angibt, wie die restlichen Daten des Datenwortes zu verarbeiten sind. Dadurch kann die Anordnung wahlweise oder abwechselnd wie die Anordnung gemäß Figur 1 oder wie die Anordnung gemäß Figur 2 oder wie die Anordnung gemäß Figur 3 arbeiten.

Ebenfalls bei allen hier vorgestellten Anordnungen kann vorgesehen werden, daß im dritten Speicher oder anderswo ein error correction code (ECC) gespeichert ist, unter Verwendung dessen Fehler in den aus dem dritten Speicher 103, 203, 310 ausgelesenen Daten erkannt und korrigiert werden können. Dadurch können auch im dritten Speicher enthaltene Fehler korrigiert werden. Unter Umständen, insbesondere wenn durch den verwendeten ECC ein erkannter Fehler nicht korrigiert werden kann, kann auch vorgesehen werden, daß die im dritten Speicher gespeicherten Datenworte, die einen nicht korrigierbaren Fehler enthalten, aus einem außerhalb der Anordnung vorgesehenen Speicher neu in den dritten Speicher geladen werden, und daß fortan die in den dritten Speicher nachgeladenen Daten verwendet werden. Das Nachladen kann durch die Hardware oder durch das von der programmgesteuerten Einheit ausgeführte Programm veranlaßt werden.

Wenn in der Anordnung ein ECC gespeichert ist, unter Verwendung dessen in den aus der Anordnung ausgegebenen Daten DOUT enthaltene Fehler erkannt und korrigiert werden können, kann vorgesehen werden, daß die im dritten Speicher 103, 203, 310 gespeicherten Daten beim Erkennen eines durch den ECC korrigierbaren Fehlers in den aus der Anordnung ausgegebenen Daten DOUT so verändert werden, daß dieser Fehler beim nächsten Zugriff auf das fehlerhafte Datenwort nicht mehr auftritt, sondern unter Verwendung entsprechender redundanter Daten korrigiert wird. Wie dies im einzelnen geschieht, hängt von den im dritten Speicher gespeicherten Informationen ab.

Bei der unter Bezugnahme auf die Figur 3 beschriebenen Anordnung müssen hierfür lediglich die Daten DR entsprechend verändert werden, oder ein neuer Eintrag im dritten Speicher generiert werden.

Bei den unter Bezugnahme auf die Figuren 1 und 2 beschriebenen Anordnungen ist es hierfür zunächst einmal erforderlich, daß sich unter den redundanten Bits, die bei jedem Zugriff auf den ersten Speicher aus dem zweiten Speicher 102, 202, 310 ausgelesen werden, ein redundantes Bit befindet, welches immer den Wert 0 aufweist, und ein anderes redundantes Bit befindet, welches immer den Wert 1 aufweist, und daß die genannten Bits jeweils an alle ersten Schalteinrichtungen 104-x, 204-x, 304-x angelegt werden. Wenn diese Voraussetzung erfüllt ist, können durch eine Modifikation der im dritten Speicher gespeicherten Steuerinformationen zur Steuerung der ersten Schalteinrichtungen, oder durch Hinzufügung entsprechender Einträge in den dritten Speicher beliebige Bits in beliebigen Datenwörtern des ersten Speichers auf den Wert 0 oder den Wert 1 gesetzt werden.

Da der dritte Speicher 103, 203, 310 im betrachteten Beispiel durch einen wiederbeschreibbaren Speicher wie beispielsweise ein RAM, eine Registerbank oder dergleichen gebildet wird, kann dessen Inhalt zu beliebigen Zeitpunkten, also auch während des normalen Betriebes der Anordnung verändert werden. Vorzugsweise wird beim Erkennen eines korrigierbaren Fehlers in den aus der Anordnung ausgegebenen Daten DOUT nicht nur der Inhalt des dritten Speichers verändert, sondern auch der Inhalt des Speichers, aus welchem der Inhalt des dritten Speichers in den dritten Speicher geladen wird. Dadurch kann erreicht werden, daß eine während des normalen Betriebes der Anordnung vorgenommene Änderung des Inhalts des dritten Speichers auch nach einem zwischenzeitlichen Ausschalten (und dem damit verbundenen Löschen des dritten Speichers) noch wirksam ist.

Wenn die Anordnung dazu ausgelegt ist, die Fehler, die in den aus dem ersten Speicher und/oder in den aus dem dritten Speicher ausgegebenen Datenworten enthalten sind, mittels eines error correction codes zu erkennen und gegebenenfalls zu korrigieren, kann vorgesehen werden,
- keine solche Überprüfung oder nur eine eingeschränkte Überprüfung, beispielsweise eine Überprüfung, durch welche nur Fehler erkannt, aber keine Fehler korrigiert werden können, durchzuführen, und
- die Speicherbereiche, die dadurch freiwerden, daß kein error correction code gespeichert wird oder ein weniger umfangreicher error correction code gespeichert wird, zur Speicherung von Redundanzdaten und/oder zur Speicherung von Steuerdaten zur Steuerung der Redundanzdaten-Verwendung zu benutzen.

Die vorstehend beschriebenen Anordnungen ermöglichen es unabhängig von den Einzelheiten der praktischen Realisierung, daß das Ersetzen von fehlerhaften Daten des ersten Speichers durch Redundanzdaten schnell und einfach durchführbar ist.

### Bezugszeichenliste

- 101: erster Speicher
- 102: zweiter Speicher
- 103: dritter Speicher
- 104-x: erste Schalteinrichtungen
- 105: zweite Schalteinrichtung
- 106: Steuereinrichtung

- 201: erster Speicher
- 202: zweiter Speicher
- 203: dritter Speicher
- 204-x: erste Schalteinrichtungen
- 205: zweite Schalteinrichtung
- 206: Steuereinrichtung
- 207: erste Vergleichseinrichtung
- 208: zweite Vergleichseinrichtung
- 209: Auswertungsenrichtung

- 301: erster Speicher
- 304-x: Schalteinrichtungen
- 306: Steuereinrichtung
- 310: weiterer Speicher

- 401: erster Speicher
- 402: erster Adreßdecoder
- 403: zweiter Adreßdecoder
- 404: Leseverstärker- und Auswahleinheit
- 405: zweiter Speicher
- 406: Leseverstärkereinheit
- 407: Steuereinrichtung
- 408: Überprüfungseinrichtung
- 409: Schalteinrichtung
- 410: Multiplexer
- 450: Bitleitungen der aus 401 auszulesenden Speicherelemente
- 451: Bitleitungen der aus 405 auszulesenden Speicherelemente

- A: Adresse
- AH: höherwertiger Teil von A
- AL: niederwertiger Teil von A
- Alx: Adreßteil
- Cx: Information
- DIN: Eingangsdaten
- DOUT: Ausgangsdaten
- DR: Daten

## Patentansprüche

1. Anordnung mit
- einem ersten Speicher (101, 201, 301) zum Speichern von Daten,
- Schalteinrichtungen (104-x, 204-x, 304-x), durch welche festgelegt wird, ob bei einem Zugriff auf den ersten Speicher die im ersten Speicher gespeicherten Daten oder andere Daten ausgegeben werden, und
- einem zweiten Speicher (102, 202, 310) zum Speichern der anderen Daten,
**dadurch gekennzeichnet,**
**daß** die Anordnung einen dritten Speicher (103, 203, 310) enthält, der durch die Adresse (A), unter Verwendung welcher auf den ersten Speicher zugegriffen wird, oder durch einen Teil (AH) dieser Adresse adressiert wird und Informationen darüber enthält, welche Daten des ersten Speichers durch andere Daten zu ersetzen sind.

2. Anordnung nach Anspruch 1,
**dadurch gekennzeichnet,**
**daß** der erste Speicher (101, 201, 301) und der zweite Speicher (102, 202, 310) durch unterschiedliche Bereiche eines einzigen Speichers gebildet werden.

3. Anordnung nach Anspruch 1,
**dadurch gekennzeichnet,**
**daß** der zweite Speicher (102, 202, 310) und der dritte Speicher (103, 203, 310) durch unterschiedliche Bereiche eines einzigen Speichers gebildet werden.

4. Anordnung nach Anspruch 1,
**dadurch gekennzeichnet,**
**daß** der dritte Speicher (103, 203, 310) durch einen umprogrammierbaren Speicher gebildet wird.

5. Anordnung nach Anspruch 1,
**dadurch gekennzeichnet,**
**daß** der dritte Speicher (103, 203, 310) durch ein RAM gebildet wird.

6. Anordnung nach Anspruch 1,
**dadurch gekennzeichnet,**
**daß** pro Bit der aus der Anordnung auszugebenden Daten (DOUT) eine Schalteinrichtung (104-x, 204-x, 304-x) vorgesehen ist.

7. Anordnung nach Anspruch 1,
**dadurch gekennzeichnet,**
**daß** die Schalteinrichtungen (104-x, 204-x, 304-x) jeweils mehrere Eingangsanschlüsse aufweisen, wobei an einen Eingangsanschluß ein Bit der im ersten Speicher gespeicherten Daten angelegt wird, und an einen oder mehrere andere Eingangsanschlüsse ein oder mehrere Bits der im zweiten Speicher (102, 202, 310) gespeicherten Daten angelegt werden.

8. Anordnung nach Anspruch 1,
**dadurch gekennzeichnet,**
**daß** die Schalteinrichtungen (104-x, 204-x, 304-x) durch Multiplexer gebildet werden.

9. Anordnung nach Anspruch 1,
**dadurch gekennzeichnet,**
**daß** die im zweiten Speicher (102, 202, 310) gespeicherten Daten Daten sind, die eigentlich im ersten Speicher (101, 201, 301) zu speichern wären, aber dort nicht gespeichert werden können, weil die für die Speicherung dieser Daten zu verwendenden Speicherelemente defekt sind.

10. Anordnung nach Anspruch 1,
**dadurch gekennzeichnet,**
**daß** bei einem Zugriff auf den ersten Speicher (101, 201, 301) auch ein Zugriff auf den zweiten Speicher (102, 202, 310) erfolgt.

11. Anordnung nach Anspruch 1,
**dadurch gekennzeichnet,**
**daß** bei einem Zugriff auf den ersten Speicher (101, 201, 301) auch ein Zugriff auf den dritten Speicher (103, 203, 310) erfolgt.

12. Anordnung nach Anspruch 1,
**dadurch gekennzeichnet,**
**daß** das Datenwort, das auf einen Zugriff auf den dritten Speicher (103, 203, 310) hin aus dem dritten Speicher ausgegeben wird, die Steuerdaten enthält, unter Verwendung welcher die Schalteinrichtungen (104-x, 204-x, 304-x) anzusteuern sind.

13. Anordnung nach Anspruch 1,
**dadurch gekennzeichnet,**
**daß** das Datenwort, das auf einen Zugriff auf den dritten Speicher (103, 203, 310) hin aus dem dritten Speicher ausgegeben wird, Daten enthält, durch welche angegeben wird, welche Schalteinrichtungen (104-x, 204-x, 304-x) so anzusteuern sind, daß sie anstelle der im ersten Speicher (101, 201, 301) gespeicherten Daten im zweiten Speicher (102, 202, 310) gespeicherte Daten durchschalten.

14. Anordnung nach Anspruch 1,
**dadurch gekennzeichnet,**
**daß** das Datenwort, das auf einen Zugriff auf den dritten Speicher (103, 203, 310) hin aus dem dritten Speicher ausgegeben wird, die Adresse enthält, unter welcher die anderen Daten gespeichert sind.

15. Anordnung nach Anspruch 1,
**dadurch gekennzeichnet,**
**daß** das Datenwort, das auf einen Zugriff auf den dritten Speicher (103, 203, 310) hin aus dem dritten Speicher ausgegeben wird, die anderen Daten enthält.

16. Anordnung nach Anspruch 1,
**dadurch gekennzeichnet,**
**daß** das Datenwort, das auf einen Zugriff auf den dritten Speicher (103, 203, 310) hin aus dem dritten Speicher ausgegeben wird, einen Adreßteil (Alx) enthält, wobei dieser Adreßteil die Adresse eines in teilweise defekten Speicherelementen gespeicherten Datenwortes innerhalb eines im ersten Speicher (101, 201, 301) liegenden Speicherbereiches ist, der durch die zur Adressierung des dritten Speichers verwendete Adresse (AH) spezifiziert wird.

17. Anordnung nach Anspruch 16,
**dadurch gekennzeichnet,**
**daß** das Datenwort, das auf einen Zugriff auf den dritten Speicher (103, 203, 310) hin aus dem dritten Speicher ausgegeben wird, weitere Daten enthält, wobei diese weiteren Daten jedoch nur verwendet werden, wenn der im Datenwort enthaltene Adreßteil (ALx) und der Teil (AL) der zur Adressierung des ersten Speichers (101, 201, 301) verwendeten Adresse (A), der in dem zur Adressierung des dritten Speichers verwendeten Adresse (AH) nicht enthalten ist, übereinstimmen.

18. Anordnung nach Anspruch 17,
**dadurch gekennzeichnet,**
**daß** die weiteren Daten Daten gemäß den Ansprüchen 14 bis 17 und 20 bis 22 umfassen.

19. Anordnung nach Anspruch 16,
**dadurch gekennzeichnet,**
**daß** dann, wenn der im Datenwort enthaltene Adreßteil (ALx) und der Teil (AL) der zur Adressierung des ersten Speichers (101, 201, 301) verwendeten Adresse (A), der in dem zur Adressierung des dritten Speichers (103, 203, 310) verwendeten Adresse (AH) nicht enthalten ist, nicht übereinstimmen, die Schalteinrichtungen (104-x, 204-x, 304-x) so angesteuert werden, daß die im ersten Speicher gespeicherten Daten aus der Anordnung ausgegeben werden.

20. Anordnung nach Anspruch 1,
**dadurch gekennzeichnet,**
**daß** das Datenwort, das auf einen Zugriff auf den dritten Speicher (103, 203, 310) hin aus dem dritten Speicher ausgegeben wird, eine Information enthält, die angibt, welche Informationen die restlichen Daten des Datenwortes repräsentieren.

21. Anordnung nach Anspruch 1,
**dadurch gekennzeichnet,**
**daß** das Datenwort, das auf einen Zugriff auf den dritten Speicher (103, 203, 310) hin aus dem dritten Speicher ausgegeben wird, eine Information enthält, die angibt, wie die restlichen Daten des Datenwortes zu verarbeiten sind.

22. Anordnung nach Anspruch 1,
**dadurch gekennzeichnet,**
**daß** das Datenwort, das auf einen Zugriff auf den dritten Speicher (103, 203, 310) hin aus dem dritten Speicher ausgegeben wird, eine Information enthält, die angibt, ob die restlichen Daten des Datenwortes überhaupt ausgewertet werden sollen.

23. Anordnung nach Anspruch 1,
**dadurch gekennzeichnet,**
**daß** unter Verwendung eines error correction codes überprüft wird, ob die aus der Anordnung ausgegebenen Daten fehlerfrei sind, und daß mittels des error correction codes korrigierbare Fehler korrigiert werden.

24. Anordnung nach Anspruch 23,
**dadurch gekennzeichnet,**
**daß** dann, wenn mittels des error correction codes ein korrigierbarer Fehler gefunden wurde, der Inhalt des dritten Speichers (103, 203, 310) so verändert wird, daß beim nächsten Zugriff auf das fehlerhafte Datenwort zumindest die fehlerhaften Teile dieses Datenwortes durch den Fehler korrigierende Daten aus dem zweiten Speicher (102, 202, 310) ersetzt werden.

25. Anordnung nach Anspruch 1,
**dadurch gekennzeichnet,**
**daß** unter Verwendung eines error correction codes überprüft wird, ob die aus dem dritten Speicher (103, 203, 310) ausgegebenen Daten fehlerfrei sind, und daß mittels des error correction codes korrigierbare Fehler korrigiert werden.

26. Anordnung nach Anspruch 25,
**dadurch gekennzeichnet,**
**daß** zumindest dann, wenn der Fehler, der in dem aus dem dritten Speicher (103, 203, 310) ausgegebenen Datenwort enthalten ist, durch den error correction code nicht korrigierbar ist, die betreffenden Daten aus einem außerhalb der Anordnung vorgesehenen Speicher neu in den dritten Speicher geladen werden.
